# EUROPEAN PATENT APPLICATION

(11) **EP 1 398 830 A1**
(43) Date of publication of application: **17.03.2004**
(21) Application number: 02425558.0
(22) Date of filing: 12.09.2002
(51) Int. Cl.: H01L 21/768

(54) **Process for the contact opening definition for the active element electric connections**

(71) Applicant: STMicroelectronics S.r.l., 20041 Agrate Brianza (Milano) (IT)
(72) Inventor: Pividori, Luca, 24035 Curno BG (IT)
(74) Representative: Mittler, Enrico

(57) **Abstract**

The present invention refers to the construction of integrated circuits. It refers more particularly to a process for the contact opening definition for the active element electric connections.

In one its embodiment the process for the contact opening definition for the active element electric connections comprises the following phases: forming on the surface of an integrated circuit a layer of BPSG; forming above the precedent layer, a transparent layer of nitride UV from a HDP process, having a thickness among 200Å and 500Å.

## Description

The present invention refers to the construction of integrated circuits. More particularly it refers to a process for the contact opening definition for the active element electric connections.

The active elements of an integrated circuit are connected one another through contacts. The number of contacts in an integrated circuit can vary from hundred thousands to about ten million.

The dimension reduction of the of the integrated circuits leads to the realization of contacts having dimensions lower and lower, and they require more and more precise and delicate processes. Also the possible presence of extraneous substances existing on the process environment can alter and contaminate the process in progress.

In view of the state of the art described, it is an object of the present invention to provide a process for the formation of the contacts in an integrated circuit that does not have the drawbacks of the known art.

According to the present invention, such object is achieved by means of a process for the contact opening definition for the active element electric connections comprising the following phases: forming on the surface of an integrated circuit a layer of BPSG; forming above the precedent layer, a transparent layer of nitride UV from a HDP process, having a thickness among 200Å and 500Å.

The features and the advantages of the present invention will be made more evident by the following detailed description of a particular embodiment, illustrated as a non-limiting example in the annexed drawings, wherein:
figures from 1 to 4 show in section some construction phases of an integrated circuit according to the known art;
figures from 5 to 7 show in section some construction phases of an integrated circuit according to the present invention.

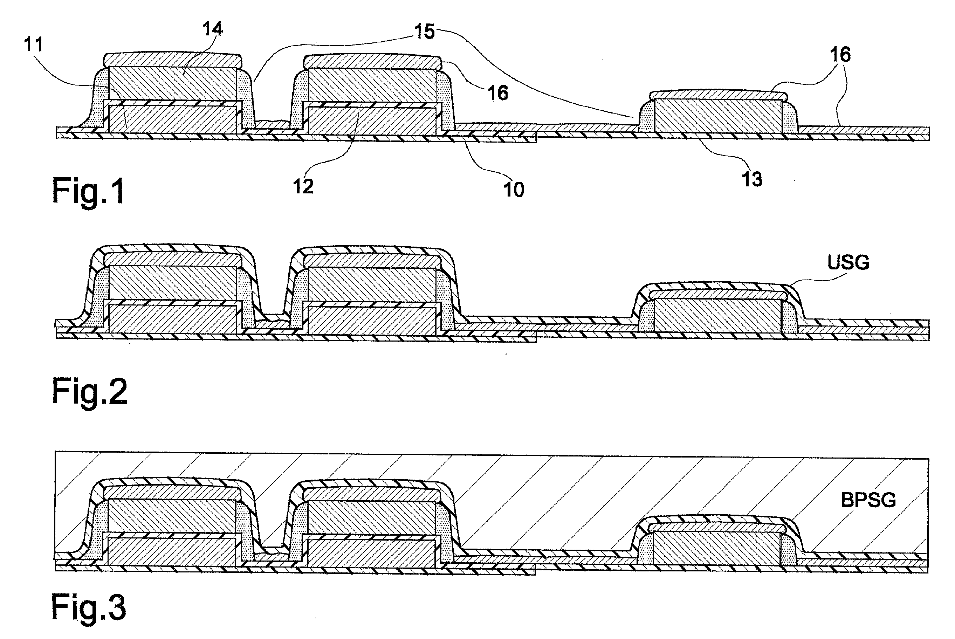

The process for the construction of an integrated circuit is normally composed of the following phases.
1) Growth of an active oxide (tunnel) 10;
2) Deposition and definition of a polysilicon layer 11 that constitutes the floating gate (poly1) only in the active matrix and its elimination from the circuits;
3) Deposition of a dielectric interpoly layer 12 for instance of the ONO (Oxide Nitride Oxide) type;
4) Through a mask (said MATRIX mask), the attack (generally in dry) of the deposed layers of oxide interpoly (for instance ONO) and of the polysilicon of the floating gate memory cells it is effected;
5) Growth of one or more layers of gate active oxides 13;
6) Deposition of a second layer of polysilicon 14;
7) Definition of the matrix cells through exposure of the auto-alignment mask;
8) Definition of the transistors gates through exposure of the circuit mask; formation of the spacers 15 of oxide or nitride; and if necessary the formation of a metallic conductive layer 16 (titanium salicide or cobalt or tungsten silicide).
   Such phases lead to an integrated circuit as schematised in figure 1.
   Subsequently the formation of the layers in which should be generated the contacts is effected.
9) Deposition of an oxide layer USG (Undoped Silicon Glass), for instance from HDP process (High Density Plasma) with a thickness among 500Å-2500Å, or of nitride (in the case in which for the formation of said contacts a process called borderless is used), as from figure 2. The presence of this layer prevents the spreading in the silicon and in the gates of contaminants deriving by the following doped layers that are deposed.
10) Deposition of a layer, for instance of BPSG (Boron Phosphorous Silicon Glass) (not necessary in the case you do not deal with non volatile memories), generally through a SACVD process (Sub Atmospheric Chemical Vapour Deposition), with concentration of the type 2:9 useful especially for memory flash devices, as from figure 3.
11) Thermal treatment with RTA (Rapid Thermal Annealing) of the deposed BPSG layer.
12) Planarization of the premetal layer of USG+BPSG for instance through CMP (Chemical Mechanical Polishing) technology.

At this point, according to the known art the contact mask is exposed, which foresees two overlapped layers of BARC (Bottom Anti Reflecting Coating) and of resist, for the masks to be used in the exposure of the DUV (Deep Ultra Violet) type.

Such layers are necessary to allow the correct definition of the contacts according to the dimensional specifications required by the product; the presence of the BARC also avoids the contamination of the resist from the doped layer of BPSG, fact that if happened it would jeopardize the final result of the lithographic process.

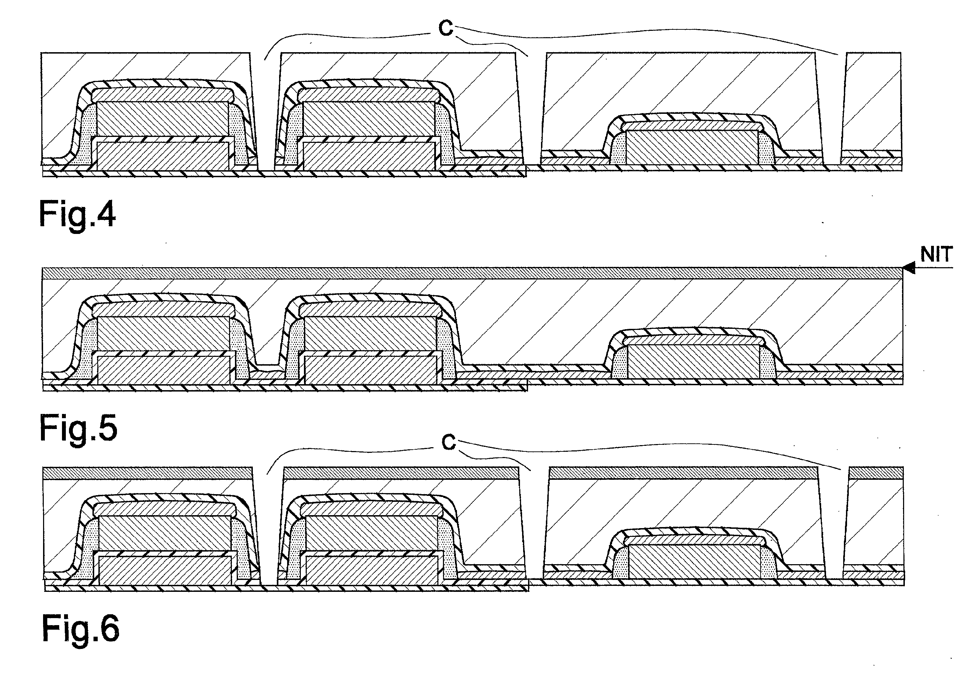

Then the selective removal of the BPSG, USG layers is effected through a dry attack of the oxide layers, generally using a chemistry of the CHF3/CF4/O2 type, usually used for the oxide attack at the contact level. Once the contact hole C is formed (see figure 4) inside the oxide layer, it is filled with W through CVD deposition of the tungsten from WF6 to form the W 'plug'; generally between the contact oxide and the W a barrier layer of TiN (or Ti/TiN) is interposed from CVD (Chemical Vapour Deposition) or PVD (Physical Vapour Deposition) to avoid contaminations of WF6 and diffusion of the W through the oxide. Through dry attack (selective with the Ti/TiN layer, which is stopped for end-point) is removed (etch back) therefore the W deposited in excess, giving definitive form to the contact. The operations of deposition of the AlCu metal layers and the definition of the circuit interconnections follow.

According to the present invention, after the phase 12, instead of immediately exposing the contact mask a transparent UV (Ultra Violet) nitride layer NIT is deposed through a HDP process, with a thickness among 200Å and 500Å, as from figure 5. The deposed layer NIT is preferably insulating in order to avoid any possible short circuit.

After that, two overlapped layers of BARC and of resist are formed, when necessary.

The deposed layer must be of a material that allows of getting a high selectivity with the BPSG during the contact attack, so that, once the resist is worn out (or it has been consumed) it develops the same function of superior barrier layer (that is above the BPSG layer) in comparison to the attack chemistry. To this purpose it could be advantageous that the deposed layer is for instance a transparent UV nitride that has high selectivity with the BPSG and does not prevent the reliability performances of the memory cell, particularly if the cell is of flash type.

The function of such a layer is that of avoiding the direct contact of the BARC+resist with the BPSG, also in case of prolonged rest of the wafers with BARC+resist already deposed and before their working (contact attack). In such a way the defectiveness formation called "corrosion" of the BPSG layer is avoided, which makes impossible the contact definition and therefore provokes a yield loss during the device testing.

Besides, such a layer avoids the formation of contacts called "with double edge", that are critical when the contact dimension is of the order of the 0.2. µm or smaller than that and the distance between the contacts is of the order of 0.5µm.

Once the barrier layer has been deposed according to the present invention, the normal operations of mask exposure of the contact and its attack is effectuated, as in figure 6. Obviously the contact attack chemistry will be modified in order to correctly attach the additional protective layer in the first phases (being in the case in object a nitride layer, a dry attack of the protective layer having a chemistry of the type C4F8/O2 will be advantageously used, that allows to have an elevated selectivity with the BPSG underlying oxide), and therefore proceeding in a standard way for instance with the chemistry CHF3/O2, of attack oxide once arrived on the BPSG.

## Claims

1. Process for the contact opening definition for the active element electric connections comprising the following phases: forming on the surface of an integrated circuit a layer of BPSG; forming above the precedent layer, a transparent layer of nitride UV from a HDP process, having a thickness among 200Å and 500Å.

2. Process according to claim 1 **characterized in that** after the phase of forming a layer of nitride UV there is the phase of forming two overlapped layers of BARC and of resist.

3. Process according to claim 1 **characterized in that** before the phase of forming on the surface of a integrated circuit a BPSG layer, there is the phase of forming a USG oxide layer having a thickness between 500Å and 2500Å.

4. Process according to claim 1 **characterized in that** after the phase of forming two overlapped layers of BARC and of resist there is the phase of chemical attack for the formation of the contact window.
